(19) **Europäisches Patentamt**
**European Patent Office**
**Office européen des brevets**

(11) **EP 1 548 857 B1**

(12) **EUROPEAN PATENT SPECIFICATION**

(45) Date of publication and mention
of the grant of the patent:
**19.03.2008 Bulletin 2008/12**

(51) Int Cl.:
***H01L 51/40*** *(2006.01)* ***B41M 5/40*** *(2006.01)*

(21) Application number: **04090480.7**

(22) Date of filing: **06.12.2004**

(54) **Method for forming a pattern of an organic thin film of an organic electroluminescence display device**

Verfahren zur Herstellung eines Musters einer organischen Dünnschicht für eine organische Elektrolumineszenzanzeigevorrichtung

Méthode de fabrication d'un motif d'un film mince organique pour un dispositif d'affichage électroluminescent organique

(84) Designated Contracting States:
**AT BE BG CH CY CZ DE DK EE ES FI FR GB GR HU IE IS IT LI LT LU MC NL PL PT RO SE SI SK TR**

(30) Priority: **22.12.2003 KR 2003094945**

(43) Date of publication of application:
**29.06.2005 Bulletin 2005/26**

(73) Proprietor: **Samsung SDI Co., Ltd.**
**Suwon-si**
**Gyeonggi-do (KR)**

(72) Inventors:
• **Kang, Tae-Min,**
**c/o Samsung SDI Co. Ltd.**
**Suwon-si,**
**Gyeonggi-do (KR)**
• **Song, Myung-Won,**
**c/o Samsung SDI Co. Ltd.**
**Suwon-si,**
**Gyeonggi-do (KR)**

• **Lee, Jae-Ho,**
**c/o Samsung SDI Co. Ltd.**
**Suwon-si,**
**Gyeonggi-do (KR)**
• **Lee, Seong-Taek,**
**c/o Samsung SDI Co. Ltd.**
**Suwon-si,**
**Gyeonggi-do (KR)**

(74) Representative: **Hengelhaupt, Jürgen et al**
**Anwaltskanzlei**
**Gulde Hengelhaupt Ziebig & Schneider**
**Wallstrasse 58/59**
**10179 Berlin (DE)**

(56) References cited:
**EP-A- 0 851 714     EP-A- 0 858 110**
**US-A1- 2003 124 265**

• **LEE S.T. ET AL: 'A new patterning method for full-color polymer light-emitting devices: Laser induced thermal imaging (LITI)' SOCIETY FOR INFORMATION DISPLAY 2002 INTERNATIONAL SYMPOSIUM DIGEST 2002, pages 784 - 787**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

BACKGROUND OF THE INVENTION

Field of the invention

The present invention relates to a donor film for laser induced thermal imaging method and an organic electroluminescence display device fabricated using the film, more particularly, to a donor film used for forming an organic layer for an organic electroluminescence display device and an organic electroluminescence display device prepared by using the donor film.

Description of Related Art

Generally, an organic electroluminescence display device is formed of various layers including an anode and a cathode, a hole injection layer, a hole transport layer, an emitting layer, an electron transport layer and an electron injection layer. The organic electroluminescence display device is divided into a polymeric organic electroluminescence display device and a small molecular organic electroluminescence display device according to materials used in the organic electroluminescence display device. The respective layers are introduced into the organic electroluminescence display device by vacuum deposition in case of the small molecular organic electroluminescence display device and by a spin coating process in case of the polymeric organic electroluminescence display device.

The single color polymeric organic electroluminescence display device is simply fabricated using a spin coating process, but the polymeric organic electroluminescence display device has problems because emission efficiency and life cycle are diminished although driving voltage is lower compared to the small molecular organic electroluminescence display device. Furthermore, when fabricating a full color organic electroluminescence display device in which red, green and blue high molecules are patterned, the polymeric organic electroluminescence display device has problems that emission characteristics including emission efficiency and life cycle are deteriorated when using inkjet technology or a laser induced thermal imaging method.

Particularly, when patterning a polymeric organic electroluminescence display device using the laser induced thermal imaging method, a single material is generally not transferred on the polymeric organic electroluminescence display device.

A method for forming patterns of a polymeric organic electroluminescence display device by the laser induced thermal imaging method is disclosed in United States Patent Nos. 5,998,085 entitled Process for preparing high resolution emissive arrays and corresponding articles by Isberg et al., issued on December 7, 1999, 6,214,520 entitled Thermal transfer element for forming multilayer devices by Wolk et al., issued on April 10, 2001, and 6,114,088 entitled Thermal transfer element for forming multilayer devices by Wolk et al., issued on September 5, 2000.

In order to apply the laser induced thermal imaging method, at least a light source, a transfer film and a substrate are required, and light coming out of the light source is absorbed into a light absorption layer of the transfer film and converted into a thermal energy so that a transfer layer forming material of the transfer film is transferred onto the substrate by the thermal energy, thereby forming a desired image as disclosed in United State Patent Nos. 5,220,348 entitled Electronic drive circuit for multi-laser thermal printer by D'Aurelio, issued on June 15, 1993, 5,256,506 entitled Ablation-transfer imaging/recording by Ellis et al., issued on October 26, 1993, 5,278,023 entitled Propellant-containing thermal transfer donor elements by Bills et al., issued on January 11, 1994, and 5,308,737 entitled Laser propulsion transfer using black metal coated substrates by Bills et al., issued on May 3, 1994.

The laser induced thermal imaging method is used in fabrication of a color filter for a liquid crystal display device and used to form patterns of emitting materials as disclosed in United State Patent No. 5,998,085 entitled Process for preparing high resolution emissive arrays and corresponding articles by Isberg et al., issued on December 7, 1999.

United State Patent No. 5,937,272 entitled Patterned organic layers in a full-color organic electroluminescent display array on a thin film transistor array substrate by Tang, issued on August 10, 1999 relates to a method for forming a high quality patterned organic layer in a full color organic electroluminescence display device, and a donor supporting body obtained by coating an organic electroluminescence substance with a transferable coating material is used in the method. The donor supporting body is heated so that the organic electroluminescence substance is transferred onto a recess surface part of the substrate for forming a colorized organic electroluminescence medium positioned in a targeted lower pixel, wherein the organic electroluminescence substance is transferred onto the pixel by applying heat or light to a donor film.

It is disclosed in United State Patent No. 5,688,551 entitled Method of forming an organic electroluminescent display panel by Littman et al., issued on November 18, 1997 that sub-pixels are formed on each pixel region by transferring organic electroluminescence substance from a donor sheet to a receiver sheet, wherein the sub-pixels are formed by transferring an organic electroluminescence substance having sublimation property from the donor sheet to the receiver sheet at low temperature of about 400 °C or less in the transferring process.

However, the organic electroluminescence substance is not completely transferred from the donor sheet to the receiver sheet when using the laser induced thermal imaging method because the stepped surface level exists on an edge part of a pixel region of the organic electroluminescence display device by a pixel defining layer. This is called as an edge open defect or a non-transfer defect. The edge open defect is generated due to a large radius of the curvature made in a layer such as the light-to-heat conversion layer or a buffer layer which is expanded by receiving laser energy. That is, the edge open defect is generated since an expanded part has a large thickness.

The edge open defect causes problems by reducing the emission efficiency and life time of the organic electroluminescence display device are deteriorated, and also reducing.

Furthermore S.T. LEE et al. "A new patterning method for full-color polymer light emitting devices: Laser induced thermal imaging (LITI)" Society for Information Display 2002, International Symposium Digest, 2002, pages 784-787 discloses the use of laser induced thermal imaging for patterning full-color polymer light emitting devices comprising an imagewise exposure of a thermal transfer film with a scanning near infrared laser.

SUMMARY OF THE INVENTION

The present invention provides a method for forming a pattern of an organic thin film of an organic electroluminescence display device, comprising: providing a transparent electrode layer on a substrate, forming a pixel defining layer having a stepped surface level on an edge part of the pixel region, providing a donor film having a base film, a light-to-heat conversion layer, a reflection layer and an organic transfer layer, the reflection layer being arranged between the light-to-heat conversion layer and the transfer layer, arranging the donor film on the substrate comprising the transparent electrode layer and the pixel defining layer; and irradiating said donor film by the use of an energy source for separating said organic transfer layer from the donor film as said light-to-heat conversion layer of the donor film is expanded due to the radiated heat, wherein the said reflection layer has a laser beam transmittance of 20% or less and the light-to-heat conversion layer is an organic film containing laser-light absorbing material and has a thickness of 0.1 to 2 $\mu$m.

Preferably the reflection layer is formed of metal. Preferably the metal is selected from the group consisting of aluminium (Al), silver (Ag), chromium (Cr), tin (Sn), nickel (Ni), titanium (Ti), cobalt (Co), zinc (Zn), gold (Au), copper (Cu), tungsten (W), molybdenum (Mo) and lead (Pb). Preferably the organic film is a mixture of pigment and polymer bonding resin of at least one meta-acrylate oligomer selected from the group consisting of acryl meta-acrylate oligomer, ester meta-acrylate oligomer, epoxy meta-acrylate oligomer and urethane meta-acrylate oligomer. Preferably the donor film further comprises a buffer layer formed on the metal layer. Preferably the buffer layer has a thickness of 0.01 to 2 $\mu$m, and the buffer layer comprises a material selected from the group consisting of metal oxide, metal sulfide, non-metal inorganic material, inert polymer and inert small molecule. Preferably the donor film further comprises a gas forming layer formed on one of an upper part and a lower part of the light-to-heat conversion layer, in combination with a metallic reflection layer.

BRIEF DESCRIPTION OF THE DRAWINGS

A more complete appreciation of the present invention, and many of the above and other features and advantages of the present invention, will be readily apparent as the same becomes better understood by reference to the following detailed description when considered in conjunction with the accompanying drawings in which like reference symbols indicate the same or similar components, wherein:

FIG. 1 is a cross sectional view showing a structure of a conventional full color organic electroluminescence display device;

FIG. 2 is a cross sectional view showing a structure of a conventional donor film for a laser induced thermal imaging method;

FIG. 3 is a drawing showing a transfer model in case of using a conventional donor film;

FIG. 4 is a graph showing a relation between a stepped surface level generated by the pixel defining layer and the edge open defect as a relation between the size of the stepped surface level (i.e., the step height) and the radius of the curvature of an expansion part of a donor film;

FIG. 5 is a drawing illustrating a transfer mechanism when transfer-patterning an organic emitting film used in an organic electroluminescence display device by using a laser;

FIG. 6 is a drawing showing a structure of a donor film for a laser induced thermal imaging method;

FIG. 7 is a graph showing energy transfer and the degree of energy absorption at respective positions of a light-to-heat conversion layer according to laser irradiation when the light-to-heat conversion layer is laid to a relatively large thickness of 4 $\mu$m when using a conventional donor film;

FIG. 8 is a graph showing energy transfer and the degree of energy absorption at respective positions of the light-to-heat conversion layer according to laser irradiation when forming the light-to-heat conversion layer of a donor film to a thickness of 0.5 $\mu$m and using a metal layer;

FIG. 9 is a drawing showing a structure of a donor film for a laser induced thermal imaging method ; and

FIG. 10 is a drawing describing a method for laser induced thermal imaging using a donor film.

DETAILED DESCRIPTION OF THE INVENTION

For reference, like reference characters designate corresponding parts throughout several views. In the drawings and the specification, a layer is shown as placed on another layer or on a substrate in order to indicate that a layer is either directly formed upon the other layer or on the substrate or, alternatively, that a layer is formed on a third layer, which, in turn, rests upon either the other layer or the substrate. Like numbers refer to like elements throughout the specification.

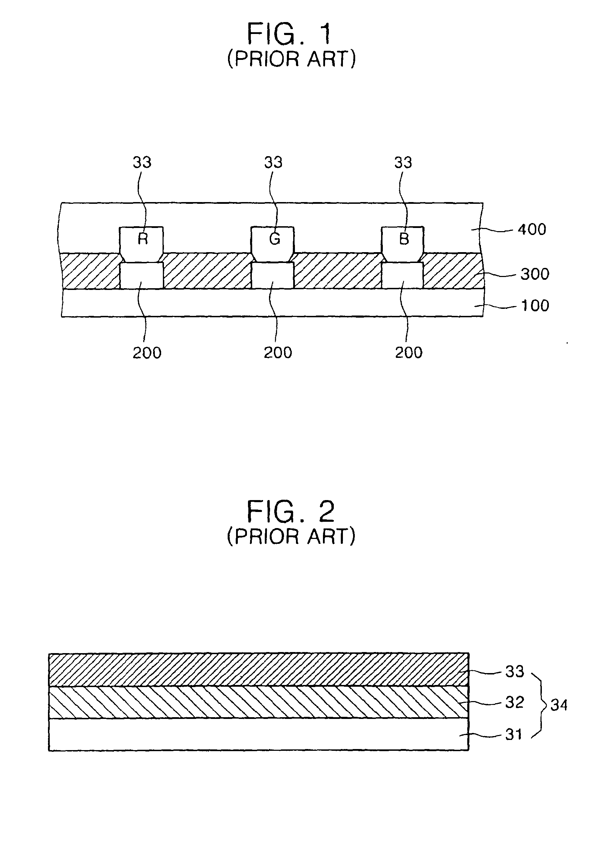

FIG. 1 is a cross sectional view for showing a structure of a conventional full color organic electroluminescence display device.

Referring to FIG. 1, a first electrode 200 is patterned on an insulating substrate 100. The first electrode 200 is formed of a transparent electrode when the full color organic electroluminescence display device is a bottom emitting type. The first electrode 200 is formed of a conductive metal with a reflection film when the full color organic electroluminescence display device is a top emitting type.

A pixel defining layer (PDL) 300 is formed of an insulating material on an upper part of the first electrode 200 to define a pixel region and to insulate an emitting layer from another emitting layer.

An organic film layer 33 made of an organic emitting layer (R, G and B) is formed on the pixel region defined by the pixel defining layer (PDL) 300, and the organic film layer 33 may include a hole injection layer, a hole transport layer, a hole blocking layer, an electron transport layer and/or an electron injection layer in addition to the organic emitting layer. Either a polymeric substance or a small molecular substance can be used as the organic emitting layer.

A second electrode 400 is formed on the organic film layer 33. The second electrode 400 is formed of a conductive metal layer with the reflection film if the first electrode 200 is a transparent electrode, and the second electrode 400 is formed of a transparent electrode if the first electrode 200 is a conductive metal layer with the reflection film. An organic electroluminescence display device is completed by sealing the organic electroluminescence display device after forming the second electrode 400.

However, as illustrated in FIG. 2, a conventional donor film 34 for laser induced thermal imaging has a base film 31, the light-to-heat conversion layer 32 and transfer layer 33 and further has a buffer layer (not shown in FIG. 2) in case of forming an emitting layer using a conventional laser induced thermal imaging.

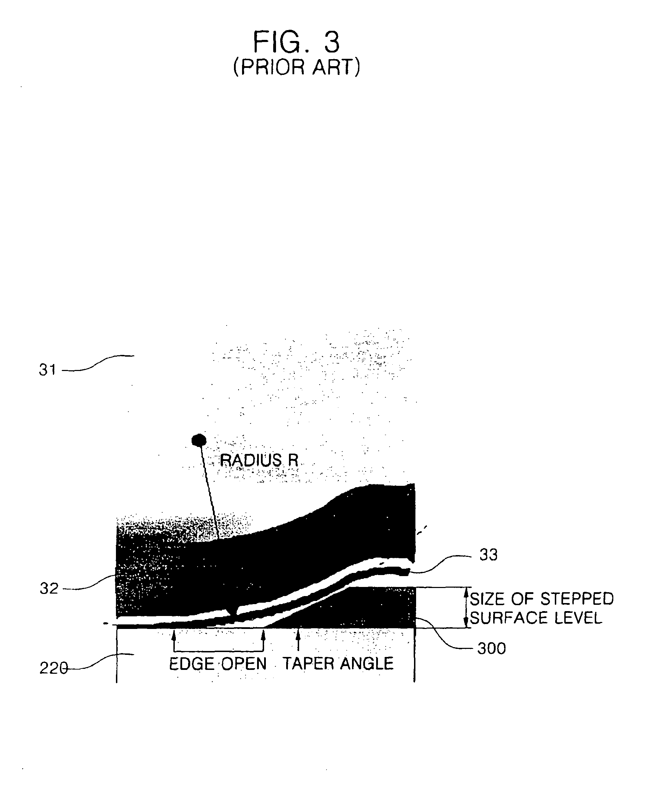

FIG. 3 relates to a transfer model when using a conventional donor film. The transfer layer 33 is separated from a donor film 34 and transferred to a substrate of an organic electroluminescence display device as the transfer layer 33 is being expanded according to expansion of a light-to-heat conversion layer 32 during laser irradiation as illustrated in FIG. 3.

However, when forming the emitting layer using the laser induced thermal imaging method, the transfer layer 33 is not completely transferred because a stepped surface level exists on an edge part of the pixel region of the organic electroluminescence display device. This is called as an edge open defect or a non-transfer defect. The edge open defect is generated due to a large radius of the curvature made in a layer such as the light-to-heat conversion layer 32 or a buffer layer (not illustrated in FIG. 3) which is expanded by receiving laser energy. That is, the thick expanded part causes the edge open defect.

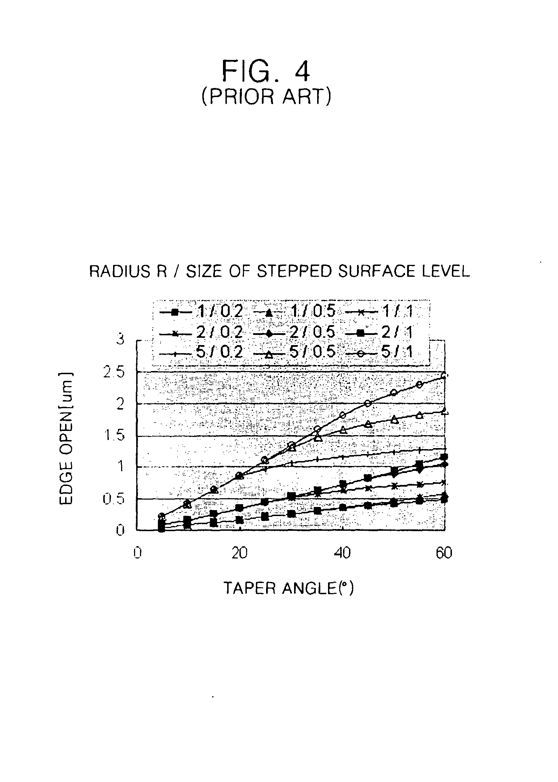

FIG. 4 is a graph showing a relation between a stepped surface level generated by the pixel defining layer and the edge open defect as a relation between the size of the stepped surface level and the radius of the curvature of an expansion part of the donor film.

As shown in FIG. 4, the larger size of the stepped surface level, the more edge open defects. Also, when the sizes of the stepped surface levels are equal, the larger radius of the curvature causes the more edge open defects. The edge open defect causes the deterioration of emission efficiency, life time and color characteristics of an organic electroluminescence display device.

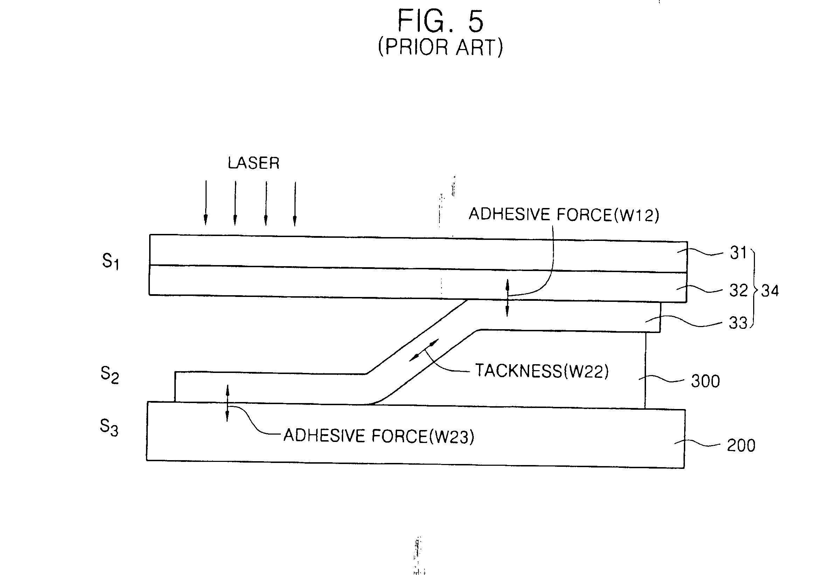

FIG. 5 is a drawing illustrating a transfer mechanism when transfer-patterning an organic emitting film used in an organic electroluminescence display device by using a laser.

In a mechanism for transfer-patterning an organic film using a conventional laser, when a laser beam is irradiated on an organic film S2, the irradiated part of the organic film S2 is detached from a substrate S1. However, the part of the organic film S2 which is not irradiated is not detached from the substrate S1 as illustrated in FIG. 5.

Factors for affecting transfer characteristics are first adhesive force $W_{12}$ between the substrate S1 and the film S2, tackiness $W_{22}$ of the film, and second adhesive force $W_{23}$ between the film S2 and the substrate S3.

The first and second adhesive forces and tackiness are represented as the following expressions using surface tensions $\gamma_1$, $\gamma_2$ and $\gamma_3$ and interfacial tensions $\gamma_{12}$ and $\gamma_{23}$ of respective layers.

$$W_{12} = \gamma_1 + \gamma_2 - \gamma_3$$

$$W_{22} = 2\gamma_2$$

$$W_{23} = \gamma_2 + \gamma_3 - \gamma_{23}$$

In order to improve laser transfer characteristics, the tackiness ($W_{22}$) of the film should be less than adhesive forces ($W_{12}$, $W_{23}$) between the respective substrates and the film.

Generally, an organic material is used in an organic electroluminescence display device as a material for forming respective layers of the organic electroluminescence display device. If a small molecular material is used as the organic material, the first and second adhesive forces are greater than the tackiness so that fine patterns of the emitting layer can be formed and the possibility of misalignment can be decreased by transferring an emitting material from a donor film 34 to the organic electroluminescence display device.

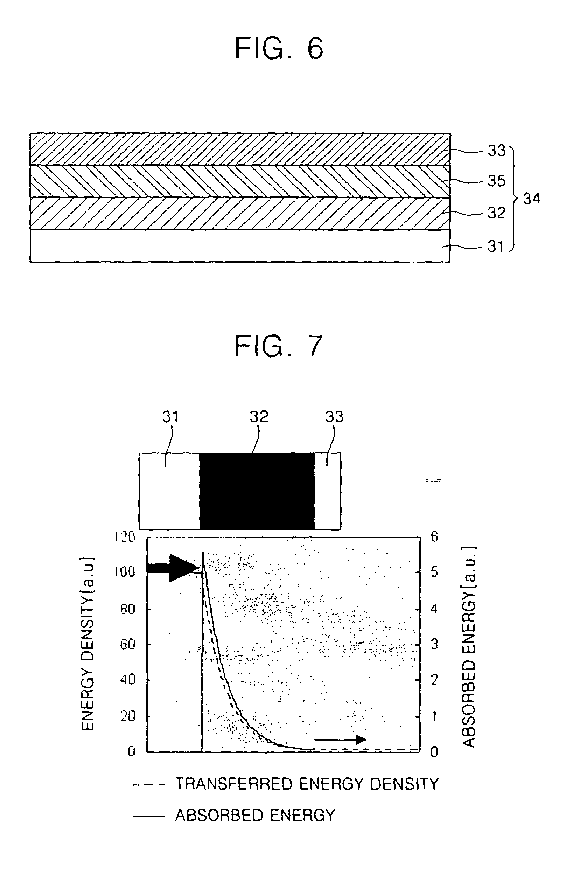

FIG. 6 is a drawing showing a structure of a donor film for small molecular laser induced thermal imaging.

Referring to FIG. 6, the donor film 34 has a structure consisting of a base film 31, a light-to-heat conversion layer 32 formed on an upper part of the base film 31, a metal layer 35 formed on an upper part of the light-to-heat conversion layer 32 over the base film 31, and a transfer layer 33 formed over an upper part of the metal layer 35. The transfer layer 33 is formed of an organic material.

The structure of the donor film of FIG. 6 can be changed according to its applications. For example, the donor film further comprises a gas forming layer (not illustrated in FIG. 6) on either an upper part or a lower part of the light-to-heat conversion layer, and a buffer layer (not illustrated in FIG. 6) formed between the metal layer 35 and the transfer layer 33 to improve sensitivity of the film.

The base film 31 is formed of transparent polymers including polyester such as polyethylene terephthalate, polyacryl, polyepoxy, polyethylene, and polystyrene. A composite multi-component substrate can be also used as the base film 31. Particularly, a polyethylene terephthalate film is mainly used as the transparent polymer. It is preferable that the base film has a thickness of 10 to 500 $\mu$m. The base film functions as a supporting substrate..

The light-to-heat conversion layer 32 is formed of a light absorbing material having a property of absorbing light in the infrared ray-visible ray range. The light-to-heat conversion layer 32 is an organic film containing laser-light absorbing material.

The organic film can be formed of polymer to which carbon black, graphite or infrared dye is added as a film having the above characteristics.

The organic film formed of polymer to which carbon black, graphite or infrared dye is added can be a polymer bonding resin in which pigment, colorant such as dyes, dispersant, etc. are dispersed. The polymer bonding resin can be meta-acrylate oligomer such as acryl meta-acrylate oligomer, ester meta-acrylate oligomer, epoxy meta-acrylate oligomer and urethane meta-acrylate oligomer, a mixture of the meta-acrylate oligomer and meta-acrylate monomer, or meta-acrylate monomer. It is preferable that the carbon black or graphite has a particle diameter of 0.5 $\mu$m or less and an optical density of 0.1 to 4.

On the other hand, if the thickness of the light-to-heat conversion layer 32 is too thin, an energy absorption ratio is lowered so that expansion pressure is lowered due to low light-to-heat conversion energy, and transmission energy is increased so that substrate circuits of an organic electroluminescence display device are damaged.

Furthermore, the edge open defect caused by stepped surface level generated by a pixel defining layer is reduced by maintaining the light-to-heat conversion layer 32 to a certain thickness or less in order to decrease the radius of the curvature during expansion of the light-to-heat conversion layer 32.

On the other hand, if the thickness of the light-to-heat conversion layer 32 is too thick, there is a strong possibility of an edge open defect due to poor close adhesion between the film and the substrate at a part of the stepped surface level generated by a pixel defining layer.

The light-to-heat conversion layer 32, which is an organic film, is laid to a thickness of 0.1 to 2 $\mu$m b y a conventional film coating method of extrusion, gravure coating, spin coating or knife coating.

FIG. 7 is a graph showing energy transfer and the degree of energy absorption at respective positions of the light-to-heat conversion layer 32 according to laser irradiation when the light-to-heat conversion layer 32 is laid to a relatively large thickness of 4 $\mu$m when using a conventional donor film. Referring to FIG. 7, it is difficult to closely attach the light-to-heat conversion layer to the substrate as a thick layer including most of the light-to-heat conversion layer, the buffer layer and the transfer layer 33 is expanded although energy efficiency is good by absorbing most of the energy at a laser beam incidence part of the light-to-heat conversion layer and absorbing most of the energy while the energy is passing through the light-to-heat conversion layer.

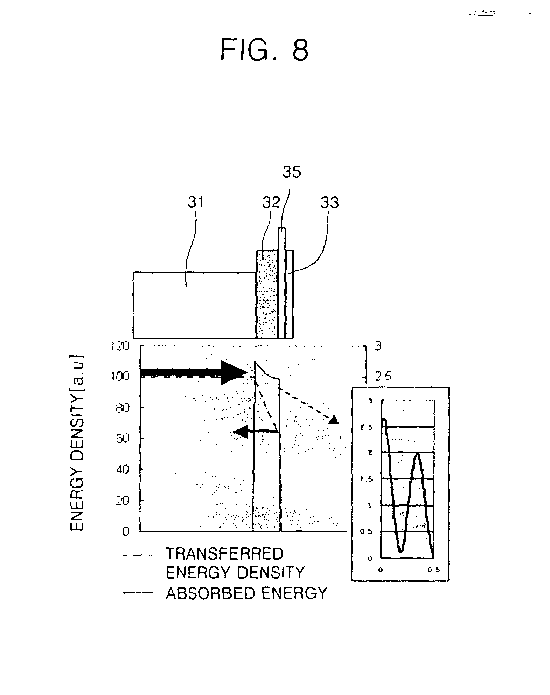

On the contrary, FIG. 8 is a graph showing energy transfer and the degree of energy absorption degree at respective positions of the light-to-heat conversion layer 32 according to laser irradiation when forming the light-to-heat conversion layer 32 of a donor film 34 with a thickness of 0.5 $\mu$m and using the metal layer 35. Referring to FIG. 8, energy absorbed into the light-to-heat conversion layer as passing through the light-to-heat conversion layer 32 according to laser irradiation is decreased since the thickness of the light-to-heat conversion layer is thinned. However, since, by using a metal reflection layer, only the small thickness of the buffer layer and the transfer layer needs to be pushed, thereby absorbing the laser light reflected by the metal reflection layer so that energy efficiency is increased, and the energy is further uniformized in the light-to-heat conversion layer so as to uniformly expand the light-to-heat conversion layer as a whole. Therefore, the light-to-heat conversion layer is easily closely adhered to the substrate even by small energy.

Furthermore, the gas forming layer plays a role of providing transfer energy by generating decomposition reaction when light or heat is absorbed into the gas forming layer, thereby emitting nitrogen gas or hydrogen gas. The gas forming layer is formed of a material selected from pentaerythritol tetranitrate (PETN), trinitrotoluene (TNT), etc. Since the gas forming layer should receive heat from the light-to-heat conversion layer, the gas forming layer is formed adjacently to either an upper part or a lower part of the light-to-heat conversion layer or mixed with material of the light-to-heat conversion layer to form a single layer.

A metal having a laser beam transmittance of 20% or less is used as a metal layer 35 formed on an upper part of the light-to-heat conversion layer 32 over the base film. Furthermore, the metal layer 35 is laid to a thickness of 1 $\mu$m or less by vacuum deposition, electron beam deposition or sputtering. Thickness of the metal layer 35 is formed to such a degree that laser light is hardly transferred onto the substrate of an organic electroluminescence display device. If the metal layer is too thick, the characteristics of the laser induced thermal imaging may be affected because the metal layer is not expanded when the light-to-heat conversion layer is expanded.

The metal layer not only prevents substrate circuits from being damaged, but also prevents gas generated in the light-to-heat conversion layer 32 from infiltrating into the transfer layer 33 since laser energy is not transferred to the substrate of an organic electroluminescence display device due to the metal layer during laser induced thermal imaging. Additionally, the metal layer 35 prevents thermal damage of the transfer layer by using a metal having high thermal conductivity to dissipate heat transferred to the transfer layer 33 from the light-to-heat conversion layer 32.

A buffer layer (not illustrated in FIG. 8) can be further formed on an upper part of the metal layer 35. The buffer layer prevents metal from being diffused into the transfer layer and controls adhesive force of the metal layer with the transfer layer so that characteristics of transfer-patterns are improved. A metal oxide, metal sulfide, nonmetal inorganic compound or organic material can be used as the buffer layer. The metal oxide can be formed by oxidizing the surface of the metal layer or proceeding a separate process after forming a metal layer. The organic material may be formed by coating an inert polymer or depositing small molecules forms the organic material. The thickness of the buffer layer is preferably 0.01 to 2 $\mu$m.

The transfer layer 33 is formed of at least one material selected from a polymeric or small molecular organic electroluminescence material, a hole transferable organic material and an electron transferable organic material so that the transfer layer corresponds to characteristics of an organic electroluminescence display device to be fabricated. The transfer layer is preferably coated to a thickness of 10 to 5000 nm (100 to 50,000 Å) by a conventional coating method including extrusion, gravure coating, spin coating, knife coating, vacuum deposition and CVD (chemical vapor deposition).

As described in the above, the laser is reflected by the metal layer 35 by introducing a metal layer 35 between the light-to-heat conversion layer 32 and the transfer layer 33 so that more energy is transferred to the light-to-heat conversion layer 32.

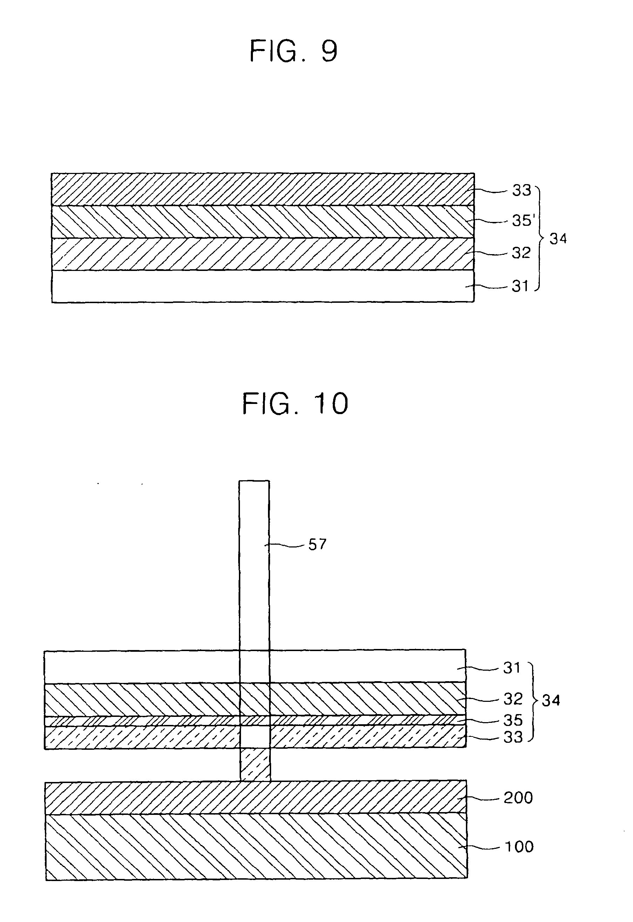

FIG. 9 is a cross sectional view of a donor film for a laser induced thermal imaging method. The donor film is constructed with a base film 31, a light-to-heat conversion layer 32 and the transfer layer 33. The donor film further comprises a reflection layer 35' for reflecting an irradiated laser to the light-to-heat conversion layer 32 and preventing gas produced from the light-to-heat conversion layer 32 from infiltrating into the transfer layer 33.

Any materials such as organic material, inorganic material and metal can be used as the reflection layer if they are capable of preventing gas from infiltrating into the transfer layer.

A material having a laser light transmittance of 20% or less is used as the reflection layer, and preferably metal is used as the reflection layer.

A metal selected from the group consisting of aluminum (Al), silver (Ag), chromium (Cr), tin (Sn), nickel (Ni), titanium (Ti), cobalt (Co), zinc (Zn), gold (Au), copper (Cu), tungsten (W), molybdenum (Mo) and lead (Pb) is used as the reflection layer.

The reflection layer is preferably laid to a thickness of 1 $\mu$m or less considering gas infiltration blocking force and laser light transmittance of the reflection layer although the thickness of the reflection layer is varied depending on a material used as the reflection layer.

Other constitutional factors adopt the same materials and methods as described in conjonction with FIG. 6.

A donor film for the laser induced thermal imaging method disclosed herein is capable of forming fine patterns easily, particularly for an organic electroluminescence display device in which emitting elements are formed of organic material.

A method for forming fine patterns on an organic thin film of an organic electroluminescence display device using a donor film referring to FIG. 10 is described in detail as follows.

FIG. 10 is a drawing describing a method for laser induced thermal imaging using a donor film, wherein a transparent electrode layer 200 is first formed on a transparent substrate 100, and a donor film 34 is prepared by sequentially coating the light-to-heat conversion layer 32, the metal layer 35 and the transfer layer 33 on a base film 31 separately from the transparent electrode layer 200.

The transfer layer 33 is formed by coating an organic thin film forming material on the metal layer 35, wherein additives may be added to the organic thin film forming material to improve various characteristics of the transfer layer 33. For example, a dopant is added to the organic thin film forming material to improve emission efficiency of an emitting layer of the transfer layer. The transfer layer 33 is formed by the foregoing conventional film coating methods including extrusion, gravure coating, spin coating and knife coating.

The transfer layer 33 is laid to one layer using an organic film as described in the above or laid to two or more of layers as occasion demands.

An energy source 57 is irradiated onto the donor film 34 after arranging the donor film 34 on a transparent electrode layer 200 formed on a substrate 100.

The energy source 57 activates the light-to-heat conversion layer 32 by passing through the base film 31 via a laser induced thermal imaging unit and radiates heat by pyrolysis. The irradiated laser beam is retroreflected by the metal layer or the reflection layer 35 so that the energy impressed to the light-to-heat conversion layer 32 is increased.

An emitting layer is transferred to desired patterns and thickness on a pixel region defined by a pixel defining layer on an upper part of the substrate 100 of an organic electroluminescence display device by separating the transfer layer 33 from the donor film 34 as the light-to-heat conversion layer 32 of the donor film is being expanded due to the radiated heat.

An edge open defect caused by stepped surface level generated according to formation of the pixel defining layer is prevented by performing laser induced thermal imaging with at least a certain thickness of the light-to-heat conversion layer 32 as in the present invention, thereby decreasing the radius of the curvature when the light-to-heat conversion layer is expanded.

A laser, a xenon (Xe) lamp, a flash lamp, etc. can be used as an energy source in the present invention. The laser among the energy sources is preferably used to obtain the most superior transfer effect. General lasers including solid, gas, semiconductor and dyes can be used, and a circular or other shaped laser beam can be used.

The laser induced thermal imaging of the transfer material is performed in one-step or multi-step. That is, an organic thin film layer to be transferred is formed to a required thickness by one transfer or several repeated transfers. However, one transfer is preferred in view of process convenience and stability forms the organic thin film layer.

As described in the above, a donor film for the laser induced thermal imaging method increases amount of energy absorbed into the light-to-heat conversion layer by forming a reflection layer or a metal layer between the light-to-heat conversion layer and the transfer layer, prevents damage of the substrate by not transmitting laser beam to the substrate and prevents deterioration of the transfer layer by preventing gas generated from the light-to-heat conversion layer by heat from penetrating into the transfer layer and dissipating heat transferred to the transfer layer.

Furthermore, edge open defect can be reduced with a thin light-to-heat conversion layer, thereby increasing close adherence between the transfer layer and the substrate at a stepped surface level part.

**Claims**

1. A method for forming a pattern of an organic thin film of an organic electroluminescence display device, comprising:

    - providing a transparent electrode layer (200) on a substrate (100),
    - forming a pixel defining layer (300) having a stepped surface level on an edge part of the pixel region,
    - providing a donor film (34) having a base film (31), a light-to-heat conversion layer (32), a reflection layer (35') and an organic transfer layer (33), the reflection layer (35') being arranged between the light-to-heat conversion layer (32) and the transfer layer (33),
    - arranging the donor film (34) on the substrate (100) comprising the transparent electrode layer (200) and the pixel defining layer (300); and
    - irradiating said donor film (34) by the use of an energy source (57) for separating said organic transfer layer (33) from the donor film (34) as said light-to-heat conversion layer (32) of the donor film (34) is expanded due to the radiated heat,

    wherein the said reflection layer (35') has a laser beam transmittance of 20% or less and the light-to-heat conversion layer (32) is an organic film containing laser-light absorbing material and has a thickness of 0.1 to 2 $\mu$m.

2. The method of claim 1, wherein the reflection layer (35') is formed of metal.

3. The method of claim 2, wherein the metal is selected from the group consisting of aluminium (Al), silver (Ag), chromium (Cr), tin (Sn), nickel (Ni), titanium (Ti), cobalt (Co), zinc (Zn), gold (Au), copper (Cu), tungsten (W), molybdenum (Mo) and lead (Pb).

4. The method of claim 1, wherein the organic light-to-heat conversion layer is formed of a mixture of pigment and polymer bonding resin of at least one meta-acrylate oligomer selected from the group consisting of acryl meta-acrylate oligomer, ester meta-acrylate oligomer, epoxy meta-acrylate oligomer and urethane meta-acrylate oligomer.

**5.** The method of claim 2, wherein
the donor film (34) further comprises a buffer layer formed on the metal layer (35/).

**6.** The method of claim 5, wherein
the buffer layer has a thickness of 0.01 to 2 $\mu$m, and the buffer layer comprises a material selected from the group consisting of metal oxide, metal sulfide, non-metal inorganic material, inert polymer and inert small molecule.

**7.** The method of claim 2, wherein
the donor film (34) further comprises a gas forming layer formed on one of an upper part and a lower part of the light-to-heat conversion layer (32).

**Patentansprüche**

**1.** Verfahren zur Herstellung eines Musters einer organischen Dünnschicht für eine organische Elektrolumineszenzanzeigevorrichtung, aufweisend:

- Bereitstellung einer transparenten Elektrodenschicht (200) auf einem Substrat (100),
- Ausbildung einer Pixeldefinitionsschicht (300), die ein abgestuftes Oberflächenniveau auf einem Randbereich der Pixelregion aufweist,
- Bereitstellung einer Donorschicht (34), die eine Basisschicht (31), eine Schicht (32) zur Umwandlung von Licht in Wärme, eine Reflexionsschicht (35') und eine organische Transferschicht (33) aufweist, wobei die Reflexionsschicht (35') zwischen der Schicht (32) zur Umwandlung von Licht in Wärme und der Transferschicht (33) angeordnet ist,
- Anordnen der Donorschicht (34) auf dem Substrat (100), das die transparente Elektrodenschicht (200) und die Pixeldefinitions-schicht (300) aufweist, und
- Bestrahlung der besagten Donorschicht (34) mittels einer Energiequelle (57), so dass die besagte organische Transferschicht (33) von der Donorschicht (34) getrennt wird, da die besagte Schicht (32) zur Umwandlung von Licht in Wärme der Donorschicht (34) aufgrund der abgestrahlten Wärme eine Dehnung erfährt, wobei die besagte Reflexionsschicht (35') einen Durchlässigkeitsgrad des Laserstrahls von 20% oder weniger aufweist, und wobei die Schicht (32) zur Umwandlung von Licht in Wärme eine organische Schicht, die ein Laserlicht absorbierendes Material enthält, ist und eine Dicke von 0,1 bis 2 $\mu$m aufweist.

**2.** Verfahren nach Anspruch 1, wobei
die Reflexionsschicht (35') aus Metall ausgebildet ist.

**3.** Verfahren nach Anspruch 2, wobei
das Metall aus der Gruppe bestehend aus Aluminium (Al), Silber (Ag), Chrom (Cr), Zinn (Sn), Nickel (Ni), Titan (Ti), Cobalt (Co), Zink (Zn), Gold (Au), Kupfer (Cu), Wolfram (W), Molybdän (Mo) und Blei (Pd) ausgewählt ist.

**4.** Verfahren nach Anspruch 1, wobei
die organische Schicht (32) zur Umwandlung von Licht in Wärme aus einem Gemisch aus Pigment und Polymerbindeharz aus zumindest einem Meta-Acrylat-Oligomer ausgebildet ist, wobei das zumindest eine Meta-Acrylat-Oligomer aus der Gruppe bestehend aus Acryl-Meta-Acrylat-Oligomer, Ester-Meta-Acrylat-Oligomer, Epoxid-Meta-Acrylat-Oligomer und Urethan-Meta-Acrylat-Oligomer ausgewählt ist.

**5.** Verfahren nach Anspruch 2, wobei
die Donorschicht (34) weiterhin eine auf der Metallschicht (35) ausgebildete Pufferschicht aufweist.

**6.** Verfahren nach Anspruch 5, wobei
die Pufferschicht eine Dicke von 0,01 bis 2 $\mu$m aufweist, und wobei die Pufferschicht ein Material aufweist, das aus der Gruppe bestehend aus Metalloxid, Metallsulfid, nichtmetallischem anorganischem Material, inertem Polymer und einem inerten kleinen Molekül ausgewählt ist.

**7.** Verfahren nach Anspruch 2, wobei
die Donorschicht (34) weiterhin eine gasbildende Schicht aufweist, die auf einem oberen Bereich oder auf einem unteren Bereich der Schicht (32) zur Umwandlung von Licht in Wärme ausgebildet ist.

**Revendications**

**1.** Procédé destiné à former un motif d'un film mince organique d'un dispositif d'affichage d'électroluminescence organique, comprenant :

- la fourniture d'une couche (200) d'électrode transparente sur un substrat (100) ;
- la formation d'une couche (300) de définition de pixel ayant un niveau de surface par paliers sur une partie de bord de la zone de pixel ;
- la fourniture d'un film (34) distributeur ayant un film (31) de base, une couche (32) de conversion lumière-chaleur, une couche (35') de réflexion et une couche (33) de transfert organique, la couche (35') de réflexion étant agencée entre la couche (32) de conversion lumière-chaleur et la couche (33) de transfert ;
- l'agencement du film (34) distributeur sur le substrat (100) comprenant la couche (200) d'électrode transparente et la couche (300) de définition de pixel ; et

- l'irradiation dudit film (34) distributeur par l'utilisation d'une source (57) d'énergie pour séparer ladite couche (33) de transfert organique du film (34) distributeur à mesure que ladite couche (32) de conversion lumière-chaleur du film (34) distributeur est étendue en raison de la chaleur rayonnée, où ladite couche (35') de réflexion possède une transmittance de rayon laser de 20 % ou moins et la couche (32) de conversion lumière-chaleur est un film organique contenant un matériau absorbant de lumière laser et possède une épaisseur de 0,1 à 2 $\mu$m.

2. Procédé selon la revendication 1, dans lequel la couche (35') de réflexion est formée de métal.

3. Procédé selon la revendication 2, dans lequel le métal est sélectionné à partir du groupe composé d'aluminium (Al), d'argent (Ag), de chrome (Cr), d'étain (Sn), de nickel (Ni), de titane (Ti), de cobalt (Co), de zinc (Zn), d'or (Au), de cuivre (Cu), de tungstène (W), de molybdène (Mo) et de plomb (Pb).

4. Procédé selon la revendication 1, dans lequel la couche organique de conversion lumière-chaleur est formée d'un mélange d'un pigment et d'une résine polymère de liaison formée d'au moins un oligomère de méthacrylate choisi dans le groupe composé d'un oligomère de méthacrylate d'acryle, d'un oligomère de méthacrylate d'ester, d'un oligomère de méthacrylate d'époxy et d'un oligomère de méthacrylate d'uréthanne.

5. Procédé selon la revendication 2, dans lequel le film (34) distributeur comporte de plus une couche tampon formée sur la couche (35) métallique.

6. Procédé selon la revendication 5, dans lequel la couche tampon possède une épaisseur de 0,01 à 2 $\mu$m, et la couche tampon comporte un matériau sélectionné à partir du groupe composé d'oxyde métallique, de sulfure métallique, de matériau inorganique non métallique, de polymère inerte et d'une petite molécule inerte.

7. Procédé selon la revendication 2, dans lequel le film (34) distributeur comporte de plus une couche de formation de gaz formée sur l'une d'une partie supérieure et d'une partie inférieure de la couche (32) de conversion lumière-chaleur.

# FIG. 1
## (PRIOR ART)

# FIG. 2
## (PRIOR ART)

# FIG. 3
## (PRIOR ART)

31

RADIUS R

33

32

SIZE OF STEPPED
SURFACE LEVEL

300

220

EDGE OPEN    TAPER ANGLE

# FIG. 4
## (PRIOR ART)

RADIUS R / SIZE OF STEPPED SURFACE LEVEL

# FIG. 5
## (PRIOR ART)

LASER

ADHESIVE FORCE(W12)

$S_1$

31
32 ⟩34
33

ADHESIVE FORCE(W12)

TACKNESS(W22)

$S_2$

300

$S_3$

ADHESIVE FORCE(W23)

200

EP 1 548 857 B1

# FIG. 6

# FIG. 7

- - - TRANSFERRED ENERGY DENSITY

——— ABSORBED ENERGY

# FIG. 8

# FIG. 9

# FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5998085 A
- US 6214520 B
- US 6114088 A
- US 5220348 A
- US 5256506 A
- US 5278023 A
- US 5308737 A
- US 5937272 A
- US 5688551 A

**Non-patent literature cited in the description**

- **S.T. LEE et al.** A new patterning method for full-color polymer light emitting devices: Laser induced thermal imaging (LITI. *ociety for Information Display 2002, International Symposium Digest,* 2002, 784-787